# EUROPEAN PATENT APPLICATION

(11) **EP 4 129 669 A1**
(43) Date of publication of application: **08.02.2023**
(21) Application number: 21780232.1
(22) Date of filing: 29.03.2021
(51) Int. Cl.: B32B 27/30, H05F 1/00, H05F 1/02, H01L 41/193, H01L 41/257, H01L 41/31, B32B 7/025

(54) **MULTILAYERED FILM, METHOD FOR PRODUCING SAME, AND USE THEREOF**

(30) Priority: 02.04.2020 JP 2020066712
(71) Applicant: Kureha Corporation, Chuo-ku Tokyo 103-8552 (JP)
(72) Inventor: IMAJI, Makoto, Tokyo 103-8552 (JP); YAMAGUCHI, Kei, Tokyo 103-8552 (JP)
(74) Representative: Hoefer & Partner Patentanwälte mbB
(86) International application number: PCT/JP2021/013199
(87) International publication number: WO 2021/200790

(57) **Abstract**

To provide a piezoelectric film that is less likely to be electrified and that can be safely handled. A multilayered film according to an embodiment of the present invention including: a piezoelectric film containing polyvinylidene fluoride; and a protective film including an antistatic layer, the piezoelectric film and the protective film being bonded.

## Description

### TECHNICAL FIELD

The present invention relates to a multilayered film, and more specifically relates to a multilayered film including a piezoelectric film, a method for producing same, and use thereof.

### BACKGROUND ART

A piezoelectric film is a film that is electrified when a pressure is applied, and the electrified film may cause intense electrostatic discharge, and handling thereof requires caution. As a method of removing the static electricity from the electrified film, a method of using a device, such as an ionizer, is available but the method requires some costs for equipment installation. In addition, even if the static electricity is removed during the production process, the piezoelectric film is electrified just by contact with another object (especially, during transport) or by unwinding from a roll due to its characteristics.

Therefore, to ensure safety of workers for transport of piezoelectric films and for production of products using piezoelectric films, piezoelectric films that are less likely to be electrified have been demanded.

To date, various techniques have been developed to suppress electrification of resin films. For example, Cited Document 1 describes a resin film including an adhesive layer on a first face, and having a surface roughness Ra of a second face arranged on the side opposite to the first face of 1.5 nm or greater. The resin film of the Cited Document 1 has a release electrification amount at the time when the second face was brought into contact with a transparent conductive layer and then released of 30 kV or less.

Furthermore, Cited Document 2 describes a release film including a release layer on one face of a polyester film having a center line average roughness of less than 0.5 µm, and an antistatic layer formed of a resin containing electrically conductive carbon black on the other face. The release film of Cited Document 2 has a surface specific resistance of an antistatic layer of 5 × 10⁴ to 5 × 10⁹ Ω/□ and a release electrification amount of -5 to +5 kV.

### CITATION LIST

### Patent Document

Patent Document 1: JP 2018-140634 A
Patent Document 2: JP 2000-158611 A

### SUMMARY OF INVENTION

### Technical Problem

However, the piezoelectric film tends to be electrified, and the amount of electrification is large, and thus known techniques described above are not targeting a piezoelectric film. The present invention is completed in light of the problems described above, and an object of the present invention is to provide a piezoelectric film that is less likely to be electrified and that can be safely handled.

### SOLUTION TO PROBLEM

To solve the problems described above, an embodiment of the present invention is a multilayered film including: a piezoelectric film containing polyvinylidene fluoride; and a protective film including an antistatic layer, the piezoelectric film and the protective film being bonded.

### ADVANTAGEOUS EFFECTS OF INVENTION

According to the multilayered film of an embodiment of the present invention, a piezoelectric film that is less likely to be electrified and that can be safely handled can be provided.

### DESCRIPTION OF EMBODIMENTS

### 1. Multilayered Film

The multilayered film of an embodiment of the present invention will be described below. In the multilayered film according to the present embodiment, a piezoelectric film and a protective film are bonded.

### Piezoelectric Film

The piezoelectric film according to the present embodiment contains polyvinylidene fluoride as a main component. Note that "as a main component" indicates that the content is 50 mol% or greater. Components, other than the polyvinylidene fluoride, that can be contained in the piezoelectric film will be described below.

The piezoelectric film according to the present embodiment has a piezoelectric constant d₃₃ of preferably 5 pC/N or greater, more preferably 8 pC/N or greater, and even more preferably 10 pC/N or greater. Furthermore, the piezoelectric constant d₃₃ of the piezoelectric film is preferably 40 pC/N or less, more preferably 35 pC/N or less, and even more preferably 30 pC/N or less.

A film having a piezoelectric constant d₃₃ in this range exhibits suitable piezoelectricity to obtain a transparent electrical conducting film and a touch panel having an adequate function.

The piezoelectric constant d₃₃ can be an index for the degree of electrification with respect to a constant pressure. Typically, as the piezoelectric constant d₃₃ is larger, the density of electric charge caused upon application of a constant pressure becomes larger, and thus the degree of electrification of the piezoelectric film can also become larger. Note that the piezoelectric constant d₃₃ in the present specification is a value calculated by applying stress to a film in a thickness direction of the film at a constant speed by using an air press, and measuring the resulting electric charge by a charge-sensitive amplifier.

The piezoelectric film according to the present embodiment has a thickness of preferably 5 µm or greater, more preferably 10 µm or greater, and even more preferably 20 µm or greater. Furthermore, the thickness of the piezoelectric film is preferably 200 µm or less, more preferably 120 µm or less, and even more preferably 80 µm or less. When a transparent electrical conducting film produced by using the piezoelectric film is further applied to a touch panel, the transparent electrical conducting film is required to have a high transparency. The transparency of the transparent electrical conducting film is affected by the thickness of the piezoelectric film which is a raw material; however, the piezoelectric film having a thickness in the range described above can provide an adequate transparency because a layer formed of the piezoelectric film is a thin layer in the transparent electrical conducting film. Thus, the piezoelectric film having a thickness in the range described above can be suitably used for a transparent electrical conducting film and a touch panel.

The piezoelectric film and the protective film are bonded in the process of producing the transparent electrical conducting film and the touch panel. Thus, the piezoelectric film preferably has less surface irregularities and has a smooth surface to the degree that the piezoelectric film can be adequately adhered to the protective film.

The polyvinylidene fluoride contained in the piezoelectric film according to the present embodiment may contain a monomer that can copolymerize with vinylidene fluoride as a structural unit in a range that the effect of the present embodiment can be achieved. Specific examples of the monomer that can copolymerize with vinylidene fluoride include fluorine-containing monomers, such as trifluoroethylene, tetrafluoroethylene, hexafluoropropylene, chlorotrifluoroethylene, and vinyl fluoride. Note that two or more types of such monomers may be contained.

Furthermore, the piezoelectric film may contain various additives in a range that the effect of the present embodiment can be achieved, for example, to improve extrusion processability at the time of film formation. Examples of additives include plasticizers, stabilizers, antioxidants, surfactants, and pigments, and these additives can be appropriately combined and used according to the application. Both organic compounds and inorganic compounds can be used as additives. The organic compound may be a polymer.

### Protective Film

The protective film according to the present embodiment is a film adhered to the piezoelectric film to remove static electricity from the piezoelectric film and also to protect the piezoelectric film from scratch and dirt, and includes an antistatic layer. The antistatic layer may contain an electrically conductive polymer, may contain a raw material to which an antistatic agent is added, may be formed by surface coating of an antistatic agent, or may be formed by a combination of these.

Examples of the electrically conductive polymer include polyacetylene, poly(p-phenylene), polythiophene, polypyrrole, polyaniline, and polyacene.

Examples of the antistatic agent include (a) various cationic antistatic agents having a cationic group such as quaternary ammonium salts, pyridinium salts, and primary to tertiary amino groups; (b) anionic antistatic agents having an anionic group such as a sulfonate group, a sulfate group, a phosphate group, and a phosphonate group; (c) amino acid-based and amino sulfate-based amphoteric antistatic agents; and (d) amino alcohol-based, glycerin-based, and polyethylene glycol-based nonionic antistatic agents. More specific examples include, but not particularly limited to, 1-octylpyridinium hexafluorophosphate, 1-nonylpyridinium hexafluorophosphate, 2-methyl-1-dodecylpyridinium hexafluorophosphate, 1-octylpyridinium dodecylbenzenesulfonate, 1-dodecylpyridinium thiocyanate, 1-dodecylpyridinium dodecylbenzenesulfonate, and 4-methyl-1-octylpyridinium hexafluorophosphate.

The antistatic layer has electrical conductivity. Thus, when a surface of an electrified target object is coated with the antistatic layer, the surface of the target object is imparted with electrical conductivity and the electric charge leaks, and thus static electricity is dispersed and removed. One indicator of the electrical conductivity is surface specific resistance. The surface specific resistance can be measured in accordance with JIS K 7194 by, for example, using a known resistivity meter.

The antistatic layer has a surface specific resistance of preferably 10¹⁴ Ω/sq or less, more preferably 10¹² Ω/sq or less, and even more preferably 10¹⁰ Ω/sq or less. When the surface specific resistance is 10¹⁴ Ω/sq or less, the electrification of the multilayered film can be prevented.

Furthermore, the antistatic layer has a surface specific resistance of preferably 10⁴ Ω/sq or greater, more preferably 10⁶ Ω/sq or greater, and even more preferably 10⁸ Ω/sq or greater. By allowing the surface specific resistance in this range, static electricity can be removed from the multilayered film without causing intense electrostatic discharge when the electrified target object is brought into contact with another object.

The thickness of the antistatic layer is not particularly limited as long as the effect thereof can be adequately exhibited, and the thickness can be appropriately selected based on the antistatic agent to be used and the like. For example, the thickness can be from 0.020 µm to 2.0 µm, and may be from 0.020 µm to 0.15 µm or from 0.10 µm to 2.0 µm.

The protective film according to the present embodiment may further contain an adhesive layer and a base material layer in addition to the antistatic layer. The protective film according to the present embodiment below contains an adhesive layer and a base material layer.

The adhesive layer is a layer having adhesiveness to adhere the protective film to the piezoelectric film. Meanwhile, in a case where the multilayered film according to the present embodiment is used for a touch panel, in many cases, the protective film is released from the piezoelectric film at the time of use. Thus, the adhesive agent is preferably a material that can adhere the protective film to the piezoelectric film and also that can allow the protective film to be released without leaving an adhesive on the piezoelectric film.

From such a perspective, examples of the adhesive agent include acrylic adhesive agents, rubber-based adhesive agents, silicone-based adhesive agents, polyester-based adhesive agents, polyurethane-based adhesive agents, polyamide-based adhesive agents, epoxy-based adhesive agents, vinyl alkyl ether-based adhesive agents, and fluorine-based adhesive agents. These adhesive agents can be used alone or as a combination of two or more types. Among these, from the perspectives of adhesiveness and releasability, an acrylic adhesive agent is suitably used.

The thickness of the adhesive layer is not particularly limited as long as the protective film can be adhered to the piezoelectric film and, for example, is preferably 3 µm or greater and 10 µm or less.

The base material layer is a resin layer to support the antistatic layer and the adhesive layer. Examples of the resin constituting the base material layer include polyesters such as polyethylene terephthalate (PET) and polybutylene terephthalate; polyolefins such as polyethylene (PE) and polypropylene (PP); halogen-containing polymers such as polyvinyl chloride, chlorinated vinyl resins, and polyvinylidene fluoride (PVDF); acrylic polymers such as polymethyl methacrylate; and styrene-based polymers such as polystyrene and styrene-methyl methacrylate copolymers. Among these, PET, PE, and PP are preferred, and PET is the most preferred.

The thickness of the base material layer is not particularly limited as long as the base material layer can support the antistatic layer and the adhesive layer, but is preferably 10 µm or greater, more preferably 20 µm or greater, and even more preferably 30 µm or greater. On the other hand, from the perspective of suppressing production costs and transportation costs of the electrically conductive film and the touch panel, the thickness of the base material layer is preferably 150 µm or less, more preferably 100 µm or less, and even more preferably 60 µm or less.

The protective film according to the present embodiment may include the antistatic layer, the adhesive layer, and the base material layer layered in any order as long as the functions and effects thereof can be exhibited. For example, the adhesive layer, the base material layer, and the antistatic layer may be layered in this order, or the adhesive layer, the antistatic layer, and the base material layer may be layered in this order. However, although details will be described below, from the perspective of removing static electricity from the piezoelectric film more effectively, the protective film preferably includes the adhesive layer, the base material layer, and the antistatic layer layered in this order.

The protective film according to the present embodiment has a thickness of preferably 10 µm or greater, more preferably 20 µm or greater, and even more preferably 30 µm or greater. When the thickness of the protective film is in this range, the piezoelectric film can be adequately protected from scratch and dirt.

Furthermore, the thickness of the protective film is preferably 150 µm or less, more preferably 100 µm or less, and even more preferably 60 µm or less. When the thickness of the protective film is in this range, production costs and transportation costs of the electrically conductive film and the touch panel can be suppressed.

The protective film according to the present embodiment is a layer to protect the protective film surface from dirt and the like until the protective film is adhered to the piezoelectric film, and the protective film may further include a release layer that is removed at the time of adhering. The material of the release layer is not particularly limited as long as the material can protect the protective film and can be easily removed. In an example, the release layer is formed of PET. The release layer may be formed on only one face of the protective film surfaces or may be formed on both faces.

### Multilayered Film

The multilayered film according to the present embodiment has a surface potential in a rolled state of preferably -5 kV or greater and 5 kV or less, more preferably -4 kV or greater and 4 kV or less, and even more preferably -3 kV or greater and 3 kV or less. The surface potential of the film can be measured by, for example, using a known electrostatic potential measuring device.

When the surface potential of the film in a rolled state is in this range, electrification is less likely to occur during transportation of the piezoelectric film in the production process or unwinding of the film, and thus intense electrostatic discharge can be prevented. Thus, a worker can safely handle the multilayered film.

The multilayered film according to the present embodiment preferably has a surface potential of the film when the multilayered film in a rolled state is pulled out at 50 cm/s of -3 kV or greater and 3 kV or less. The surface potential is more preferably -2 kV or greater and 2 kV or less, and even more preferably -1 kV or greater and 1 kV or less.

When the electric potential is in this range, the electrification of the film is less likely to occur when the multilayered film in a rolled state is pulled out, even if electrostatic discharge occurred, no pain is felt in a hand by the electric shock. Thus, a worker can safely handle the multilayered film.

In the multilayered film according to the present embodiment, as described above, the piezoelectric film and the protective film are adhered interposing the adhesive layer of the protective film therebetween. In the multilayered film, the piezoelectric film, the adhesive layer, the base material layer, and the antistatic layer may be layered in this order, or the piezoelectric film, the adhesive layer, the antistatic layer, and the base material layer may be layered in this order; however, the former is preferred.

This is because static electricity is removed from the piezoelectric film by leaking the electric charge from the surface thereof, the antistatic layer can remove the static electricity from the piezoelectric film more efficiently in a case where the antistatic layer is arranged on the outer side of the multilayered film. That is, electrification of the multilayered film can be suppressed.

### 2. Method for Producing Multilayered Film

The method for producing the multilayered film according to the present embodiment includes performing polarizing to obtain a piezoelectric film, adhering the piezoelectric film and a protective film to obtain a multilayered film, and winding the multilayered film.

### Polarizing

The polarizing is a process of polarizing an extruded film before winding, the extruded film containing polyvinylidene fluoride, to obtain a piezoelectric film. The extruded film containing polyvinylidene fluoride can be obtained by a known method, and the method is not limited. An example is a method in which a polyvinylidene fluoride resin containing polyvinylidene fluoride is melt-extruded and stretched.

In the method of melt extrusion, for example, polyvinylidene fluoride and additives that constitute a polyvinylidene fluoride resin are supplied to an extruder by using a known dry mixing apparatus. The raw materials are heat-melted in a cylinder of the known extruder and extruded from a T-die or an annular die (circular die), and thus a plate-like film or a tube-like film is obtained.

The stretching method is not particularly limited and, for example, the plate-like film or the tube-like film can be stretched by uniaxial or biaxial stretching by a known stretching method, such as a tenter method, a drum method, or an inflation method.

The extruded film before winding is then polarized. The polarization can be performed by, for example, applying a direct current through the extruded film and applying voltage. The voltage may be appropriately adjusted based on the thickness of the extruded film and, for example, may be approximately from 1 kV to 50 kV.

In the present embodiment, as described above, the piezoelectric film can be obtained by polarizing the extruded film. Note that, in the polarizing, after the extruded film is obtained, the film may be cooled before the polarization.

### Adhering

The adhering is a process of adhering the piezoelectric film before winding and a protective film including an antistatic layer to obtain a multilayered film. At this time, the piezoelectric film and the protective film are adhered interposing the adhesive layer of the protective film therebetween. Note that, in the present embodiment, the protective film is described as having an adhesive layer; however, when the protective film does not contain an adhesive layer, the piezoelectric film and the protective film may be adhered after an adhesive agent is applied on the protective film.

Before the piezoelectric film and the protective film are adhered, the piezoelectric film may be heated. Accordingly, the piezoelectric film is heat fixed and the strain is mitigated. When the heat-fixed piezoelectric film is used, heat shrinkage that can occur in process after adhering of the multilayered film can be reduced. The heating of the piezoelectric film may be performed, for example, at 90 to 140°C for approximately 15 to 120 seconds.

### Winding

The winding is a process of winding the multilayered film. The multilayered film is, for example, wound around a roller core. The tension and speed during winding may be appropriately adjusted based on the thickness of the multilayered film and the like in a manner that tightening does not occur.

When the multilayered film is wound, the protective film may be positioned on the inner side, or the piezoelectric film may be positioned on the inner side. Furthermore, the once wound multilayered film may be wound again in the process thereafter, and the back side and the front side of the film may be reversed at this time.

In the method for producing the multilayered film according to the present embodiment, by the process of adhering the piezoelectric film and the protective film, static electricity of the piezoelectric film can be removed. Furthermore, the multilayered film produced by the production method according to the present embodiment can be safely handled because electrification of the piezoelectric film is less likely to occur due to the piezoelectric film and the protective film being bonded.

### 3. Use of Multilayered Film

The multilayered film according to an embodiment of the present invention is a resin film using the piezoelectric film as a raw material and can be suitably used for a transparent electrical conducting film. The transparent electrical conducting film can be produced by allowing a metal oxide, such as Sn-doped indium oxide or fluorine-doped tin oxide, to attach to the multilayered film surface produced by the method described above, and then releasing the protective film. The attachment of the metal oxide to the multilayered film surface can be performed by, for example, a sputtering method or a vapor deposition method. Any one of the attachment of the metal oxide and the release of the protective film may be performed earlier than the other. Furthermore, a desired transparent electrical conducting film can be obtained by appropriately performing, as necessary, corona treatment, wet coating treatment, and annealing treatment.

Furthermore, the transparent electrical conducting film obtained by the method described above can be applied to a touch panel provided in smartphones, tablet terminals, and car navigation systems. That is, a 3D touch sensor, in which a third sensor for detecting a pressing force is added, can be realized for a known touch panel that two dimensionally detects a position.

### 4. Summary

As described above, the multilayered film according to an embodiment of the present invention is a multilayered film including: a piezoelectric film containing polyvinylidene fluoride; and a protective film including an antistatic layer, the piezoelectric film and the protective film being bonded.

Furthermore, the piezoelectric film preferably has a piezoelectric constant d₃₃ of 5 pC/N or greater and 40 pC/N or less.

Furthermore, the piezoelectric film preferably has a thickness of 5 µm or greater and 200 µm or less.

Furthermore, the antistatic layer preferably has a surface specific resistance of 10¹⁴ Ω/sq or less.

Furthermore, the protective film preferably further includes a base material layer, and the piezoelectric film, the base material layer, and the antistatic layer are preferably layered in this order.

Furthermore, a surface potential of the film when the multilayered film in a rolled state is pulled out at 50 cm/s is preferably -3 kV or greater and 3 kV or less.

The method for producing a multilayered film according to an embodiment of the present invention is a method for producing a multilayered film including: polarizing an extruded film before winding to obtain a piezoelectric film, the extruded film containing polyvinylidene fluoride; adhering the piezoelectric film before winding and a protective film including an antistatic layer to obtain a multilayered film; and winding the multilayered film.

The method for producing a transparent electrical conducting film according to an embodiment of the present invention is a method for producing a transparent electrical conducting film including: attaching a metal oxide on a surface of a multilayered film produced by the method for producing a multilayered film described above; and releasing a protective film.

Embodiments of the present invention will be described in further detail hereinafter using examples. The present invention is not limited to the examples below, and it goes without saying that various aspects are possible with regard to the details thereof. Furthermore, the present invention is not limited to the embodiments described above, and various modifications are possible within the scope indicated in the claims. Embodiments obtained by appropriately combining the technical means disclosed by the embodiments are also included in the technical scope of the present invention. In addition, all of the documents described in the present specification are herein incorporated by reference.

### Examples

### 1. Preparation of Film

### Example 1

A resin film (thickness: 120 µm) formed of polyvinylidene fluoride (PVDF; available from Kureha Corporation) having an inherent viscosity of 1.3 dL/g was passed through a preheat roll heated to a surface temperature of 110°C. The film passed through the preheat roll was then passed through a stretching roll heated to a surface temperature of 120°C and stretched to the stretching ratio of 4.2 times, and thus a PVDF film was obtained.

After the stretching, polarization treatment was performed by passing the PVDF film through a polarization roll, and thus a piezoelectric film was obtained. Specifically, needle electrodes were placed at positions that were approximately 10 mm distanced from the surface of the polarization roll, and direct-current voltage was applied between the needle electrodes. At this time, the direct-current voltage was increased from 0 kV to 11 kV. The film after the polarization treatment was heat-treated at 130°C for 1 minute, and thus a final piezoelectric film was obtained.

The piezoelectric constant d₃₃ of the piezoelectric film was determined. Specifically, by using an air press, stress was applied at a constant speed in a thickness direction of the piezoelectric film, and the resulting electric charge was measured by a charge-sensitive amplifier.

Then, as a protective film including an antistatic layer, a film having a thickness of 38 µm (base material: polyethylene terephthalate) was prepared. The measurement of surface specific resistance of the antistatic layer was performed in accordance with JIS K 6911 by using a resistivity meter (Loresta GP MCP-HT800, available from Mitsubishi Chemical Analytech Co., Ltd.). The measurement of the surface specific resistance was performed three times, and the average value of the three is shown in Table 1 as a representative value.

The protective film and the piezoelectric film were adhered by using a multicoater and then wound in a roll form. For the multicoater, the line speed was set to 5 m/min, and the laminate roll contact pressure was set to approximately 0.3 N.

### Example 2

In the polarization treatment, the same operation as in Example 1 was performed except for increasing the direct-current voltage from 0 kV to 9 kV instead of increasing from 0 kV to 11 kV.

### Example 3

The same operation as in Example 1 was performed except for using a protective film ("KB-003" available from Fujimori Kogyo Co., Ltd.) having a different surface specific resistance of the antistatic layer.

### Example 4

The same operation as in Example 2 was performed, and thus a piezoelectric film was obtained.

Then, as a protective film including an antistatic layer, a film having a thickness of 32 µm (base material: PVDF) was produced. Specifically, the protective film was produced as described below. A resin film (thickness: 120 µm) formed of polyvinylidene fluoride (PVDF; available from Kureha Corporation) was stretched to the stretching ratio of 4.2 times. Then, using a multicoater with a line speed set to 2 m/min, an antistatic agent ("ARACOAT AS601D" available from Arakawa Chemical Industries, Ltd.) in which the solid content concentration was adjusted to 3.5% was applied on a surface of the stretched resin film in the coating amount of 3 g/m². Then, the resin film was dried at 100°C for 1 minute, and then wound in a roll form. Then, on a face that was on the back side of the face on which the antistatic agent was coated (i.e., back face) in the resin film, an adhesive agent ("SK-Dyne 1499M" available from Soken Chemical & Engineering Co., Ltd.) in which the solid content concentration was adjusted to 15% by using ethyl acetate was applied in the coating amount of 22 g/m². Then, the resin film was dried at 100°C for 1 minute, and thus a protective film having the antistatic layer on the front face and the adhesive layer on the back face was obtained. The measurement of surface specific resistance of the antistatic layer was performed in accordance with JIS K 6911 by using a resistivity meter (Hiresta MCP-HT800, available from Nittoseiko Analytech Co., Ltd.). The measurement of the surface specific resistance was performed three times, and the average value of the three measurements was shown in Table 1 as a representative value.

The protective film and the piezoelectric film were adhered by using a multicoater and then wound in a roll form. For the multicoater, the line speed was set to 5 m/min, and the laminate roll contact pressure was set to approximately 0.3 N. As described above, a multilayered film in which the piezoelectric film, the base material layer (PDVF), and the antistatic layer were layered in this order, was obtained.

### Example 5

The same operation as in Example 4 was performed except for applying an antistatic agent ("BONDEIP-PA100" available from Konishi Co., Ltd.) in which the solid content concentration was adjusted to 10% by using a mixture of water:isopropyl alcohol of 2:1.5 (weight ratio) in the wet coating amount of 3 g/m² in place of the antistatic agent described above at the time of application of the antistatic agent on the surface of the resin film.

### Comparative Example

The same operation as in Example 1 was performed except for winding only the piezoelectric film in a roll form.

### 2. Evaluation of Physical Properties

For each of the films in wound states prepared in Examples 1 to 3 and Comparative Example, the surface potential (kV) of the film was measured by using an electrostatic potential measuring device (SK-H050, available from Keyence Corporation). The measurement was performed at a position 10 cm from the film surface of the outside of the roll.

Furthermore, the surface potential of the film when the film was pulled out from the roll at 50 cm/s was measured. The measurement was performed at a position 10 cm from the film surface of the outside of the roll. When the film was pulled out from the roll, the electrostatic potential measuring device was fixed so that the measurement was performed at a fixed distance.

### Table 1

**Table 1**

| | Piezoelectric film thickness [µm] | Piezoelectric constant d₃₃ [pC/N] | Surface specific resistance [Ω/sq] | Surface potential [kV] | |
|---|---|---|---|---|---|
| | | | | In roll form | When pulled out |
| Example 1 | 42 | 20.6 | 1.0 × 10¹⁰ | 0 | 0 |
| Example 2 | 40 | 16.7 | 1.0 × 10¹⁰ | 0 | -0.2 |
| Example 3 | 42 | 20.6 | 4.1 × 10¹⁰ | -0.10 | -0.5 |
| Example 4 | 40 | 16.7 | 1.0 × 10⁹ | 0 | -0.2 |
| Example 5 | 40 | 16.7 | 6.0 × 10⁹ | 0 | -0.4 |
| Comparative Examples | 42 | 20.6 | > 1.0 × 10¹⁵ | -4.2 | -25.2 |

## Claims

1. A multilayered film comprising:
a piezoelectric film containing polyvinylidene fluoride; and
a protective film including an antistatic layer, the piezoelectric film and the protective film being bonded.

2. The multilayered film according to claim 1, wherein the piezoelectric film has a piezoelectric constant d₃₃ of 5 pC/N or greater and 40 pC/N or less.

3. The multilayered film according to claim 1 or 2, wherein the piezoelectric film has a thickness of 5 µm or greater and 200 µm or less.

4. The multilayered film according to any one of claims 1 to 3, wherein the antistatic layer has a surface specific resistance of 10¹⁴ Ω/sq or less.

5. The multilayered film according to any one of claims 1 to 4, wherein
the protective film further includes a base material layer, and
the piezoelectric film, the base material layer, and the antistatic layer are layered in this order.

6. The multilayered film according to any one of claims 1 to 5, wherein a surface potential of the film when the multilayered film in a rolled state is pulled out at 50 cm/s is -3 kV or greater and 3 kV or less.

7. A method for producing a multilayered film comprising:
polarizing an extruded film before winding to obtain a piezoelectric film, the extruded film containing polyvinylidene fluoride;
adhering the piezoelectric film before winding and a protective film including an antistatic layer to obtain a multilayered film; and
winding the multilayered film.

8. A method for producing a transparent electrical conducting film comprising:
attaching a metal oxide on a surface of a multilayered film produced by using the method for producing a multilayered film according to claim 7; and
releasing a protective film.
